# DEMANDE DE BREVET EUROPEEN

(11) **EP 1 635 381 A2**
(43) Date de publication de la demande: **15.03.2006**
(21) Numéro de dépôt: 05107567.9
(22) Date de dépôt: 17.08.2005
(51) Int. Cl.: H01L 21/00

(54) **Support de substrats minces**

(30) Priorité: 08.09.2004 FR 0451992
(71) Demandeur: ALCATEL, 75008 Paris (FR)
(72) Inventeur: Puech, Michel, 74370 Metz-Tessy (FR); Guichenal, M. Xavier, 74270 Chilly (FR)
(74) Mandataire: Lamoureux, Bernard

(57) **Abrégé**

La présente invention a pour objet un dispositif destiné à supporter un substrat semi-conducteur (4), comprenant un porte-échantillon (1) solidaire de la chambre de procédé comportant un système de refroidissement (2, 3) et des moyens de liaison électrique (11); Le dispositif comporte en outre un élément (5a) intermédiaire relié électriquement et thermiquement et fixé par voie électrostatique ou au moyen de mors sur ledit porte-échantillon (1). L'élément intermédiaire (5a) comporte une base (7) constituée d'un premier matériau ayant une conductivité thermique supérieure à celle du substrat (4), une première couche (8) recouvrant la base (7) constituée d'un deuxième matériau ayant une rigidité diélectrique élevée, deux électrodes (9a, 9b) disposées sur la première couche (8), et une deuxième couche (12), recouvrant la première couche (8) et les électrodes (9a, 9b), constituée d'un troisième matériau ayant une rigidité diélectrique élevée. L'élément intermédiaire (5a) est amovible et présente une rigidité suffisante pour permettre la manipulation du substrat aminci qu'il supporte.

## Description

La présente invention concerne le domaine du traitement par plasma de substrats semi-conducteurs, et en particulier la gravure et /ou dépôt par plasma. L'invention se rapporte plus précisément à un support destiné à des substrats minces dont l'épaisseur est inférieure à 500µm.

Dans l'industrie des semi-conducteurs, la manipulation des substrats sous forme de tranches représente un aspect important du procédé de fabrication. Après la réalisation des circuits intégrés sur des tranches épaisses de substrats semi-conducteurs, comme par exemple en silicium, celles-ci doivent être amincies par action mécanique jusqu'à atteindre l'épaisseur désirée selon leur application. Cette action d'amincissement a deux conséquences :
a) amincis jusqu'à des épaisseurs de l'ordre de 100 µm ou moins, les substrats jusqu'alors rigides deviennent flexibles et souples, leur manipulation est alors très difficile ;
b) l'action mécanique entraîne une modification de la structure du matériau sur une profondeur de 10 à 30 µm : la structure du substrat, qui était monocristallin, à été amorphisée. Le substrat aminci va donc devoir subir un traitement ultérieur qui consiste à enlever cette couche.

Selon un procédé d'amincissement connu, les tranches sont revêtues d'un film de matière plastique sur leur face avant sur laquelle ont été réalisés les circuits intégrés. Puis elles sont introduites dans une machine de rodage ("grinding" en anglais) dans laquelle elles vont être amincies par action mécanique sur leur face arrière. La tranche amincie va ensuite subir un deuxième traitement qui consiste à enlever, par une action de polissage mécanique ou chimique, la couche superficielle modifiée par l'amincissement.
Après ces deux étapes, le substrat semi-conducteur est fixé par sa face amincie sur un support constitué d'un film plastique supporté par un cadre métallique. Puis la face avant du substrat est débarrassée de son film plastique. L'ensemble film supporté/substrat est alors introduit dans une machine de sciage. Dans cette machine, la lame de la scie va pénétrer dans la totalité de l'épaisseur du substrat, en parcourant tous les traits de découpe, afin d'individualiser les circuits qui restent fixés sur le film plastique. L'ensemble film supporté/substrat est alors retiré de la machine de sciage et les circuits sont prêts à être montés dans leur boîtier. Ce procédé a pour principal inconvénient de générer des éclats de silicium sur les bords des circuits. Ces éclats provoqués par la lame de la scie sont à l'origine de défauts pouvant aller jusqu'au bris du circuit.
Une variante de ce procédé (appelée DBG : « Dicing By Grinding » ou DBT : « Dicing By Thinning ») permet de réduit le nombre de défauts générés par la lame de la scie sans toutefois les éliminer. Avant l'opération d'amincissement, la tranche épaisse de substrat semi-conducteur est partiellement sciée depuis sa face avant, la lame de la scie pénétrant dans le substrat jusqu'à une profondeur légèrement supérieure à l'épaisseur finale du substrat. La face avant de la tranche est alors recouverte d'un film de plastique protecteur, et la tranche épaisse est introduite dans la machine de rodage pour y être amincie par action mécanique jusqu'à rencontrer le fond des traits de scie. Les circuits se trouvent ainsi séparés et gardent la forme d'une tranche de substrat aminci qui sera alors polie mécaniquement ou chimiquement pour enlever la couche amorphisée.

Une nouvelle technique est ensuite apparue consistant à remplacer la scie, utilisée pour la séparation mécanique des circuits, par un usinage ou une gravure par plasma d'une tranchée entre les circuits. La gravure par plasma étant une action d'enlèvement de matière par phénomène physico-chimique, il n'y a aucun risque de génération de défauts d'origine mécanique. Les défauts résultants de cette opération seront donc minimum. La gravure par plasma peut avantageusement remplacer la lame de la scie pour la séparation des circuits que ce soit avant ou après amincissement, mais aussi pour remplacer les techniques de polissage pour l'enlèvement de la couche de silicium amorphisée après l'amincissement par rodage.
Selon la technique de gravure par plasma, on réalise une étape de photolithographie sur une des faces du substrat semi-conducteur délimitant ainsi les zones qui seront exposées au plasma et donc gravées, de celles qui en seront protégées par le masque en résine photosensible. On place le substrat semi-conducteur sur un porte-échantillon placé dans une enceinte. Dans cette enceinte on crée un plasma dans un gaz à basse pression, contenant par exemple du fluor comme le SF_{6.} Simultanément, on polarise négativement le porte-échantillon pour accélérer le bombardement de la surface du substrat par les ions positifs, ce qui va accélérer la gravure du matériau et accentuer la verticalité de la gravure.

Pendant l'action de gravure, le substrat est soumis à des flux de chaleur qui ont pour conséquence l'élévation de sa température de surface. Pour ne pas endommager le masque de gravure en résine photosensible et ne pas détériorer les circuits électroniques présents dans le substrat, il faut refroidir le substrat pendant toute l'opération de gravure afin de maintenir sa température à une valeur inférieure à 80-100°C. Pour refroidir le substrat, on le maintient en contact par un moyen mécanique ou électrostatique avec la surface du porte-échantillon muni d'un système de refroidissement, et on injecte du gaz Hélium entre la face supérieure du porte-échantillon et la face inférieure du substrat. Ce gaz transporte les calories du substrat vers le porte échantillon.
Pour être thermiquement efficace, la pression de l'Hélium doit être supérieure à 10 mbar environ. Si cette pression ne pose pas de problème dans le cas de tranches épaisses, elle a tendance à déformer les tranches amincies de substrat, notamment lorsqu'elles sont composées de circuits individualisés. Il est donc indispensable de fixer de manière réversible les tranches de substrat après amincissement sur un support rigide.

Une première technique consiste à fixer la tranche amincie de substrat sur un support rigide à l'aide d'un film de polymère adhésif.
On a suggéré de fixer le substrat aminci sur un substrat semi-conducteur d'épaisseur standard à l'aide d'un film qui a la propriété de perdre ses qualités d'adhésion lorsqu'il est soumis à une température élevée (« Thermal tape »), ce qui doit permettre de prélever les circuits individualisés. En pratique il est très difficile de séparer les circuits de leur support sans les détruire complètement, le film conservant une fois chauffé des propriétés d'adhésion supérieures à la résistance mécanique du silicium mince.
On a aussi envisagé de fixer le substrat aminci sur une pièce de quartz rigide, d'épaisseur 1mm environ, à l'aide d'un film qui a la propriété de perdre ses qualités d'adhésion lorsqu'il est irradié au travers du quartz par un rayonnement Ultra-Violet (« UV tape »). Cette technique présente deux inconvénients majeurs. D'abord le quartz est un très mauvais conducteur de la chaleur (conductivité : 1 W/m.K) comparé au silicium (156 W/m.K). Sa résistance thermique est donc très élevée, et la surface du substrat de silicium atteint rapidement une température supérieure à 80-100°C. La seule solution est alors de diminuer la vitesse de gravure ceci au détriment de la productivité. Ensuite le quartz est électriquement isolant et ne permet pas le maintien du substrat sur le porte-échantillon par voie électrostatique.

Une deuxième technique consiste à fixer par voie électrostatique la tranche amincie de substrat sur un support mobile.
Le document US-2002/110,449 propose de maintenir le substrat sur un support transportable sur lequel il reste fixé pendant et entre les étapes du procédé. Ce support comprend comme matériau diélectrique un matériau céramique, comme le quartz, le verre, les oxydes d'aluminium ou de titane, et le titanate de baryum. Il intègre les circuits électriques permettant de charger et de maintenir accumulées les charges électriques qui génèrent la force électrostatique.
Ce système comporte deux inconvénients majeurs. D'abord la céramique d'épaisseur 0.3 à 2.5 mm présente une résistance thermique élevée. Si le support transportable est maintenu sur le porte-échantillon par un moyen mécanique, la céramique dont l'épaisseur est faible se déformera en son centre sous l'effet de la pression de l'hélium. Cette déformation provoquera une inhomogénéité du transfert thermique (chaleur plus élevée au centre) ainsi qu'un risque très élevé de dégradation du substrat de silicium qui subira cette déformation.
Ensuite, les électrodes étant chargées avant l'étape suivante du procédé, le système électrostatique ne peut fonctionner que si les charges électriques accumulées dans les électrodes y restent tout au long de l'opération. Dans le cas présent d'une opération de gravure sèche dans un milieu plasma sous vide avec une polarisation alternative du substrat à des fréquences comprises entre 30Khz et 13,56Mhz, les électrodes n'étant pas alimentées en permanence risquent de se décharger, entraînant la perte de la force de maintien électrostatique du substrat.

Le document US-2004/037,692 décrit un porte-substrat mobile destiné à résister au traitement d'un substrat (par exemple un dépôt métallique en face arrière ou la soudure du substrat sur une embase) au cours duquel la température du substrat peut dépasser 400°C. Le porte-substrat comporte une base constituée préférentiellement d'un matériau semi-conducteur céramique (ALO2, Kapton, SiC) dont la conductivité thermique n'est pas très élevée, recouverte d'une couche en matériau isolant (SiO₂, Si₃N₄). Ce porte-substrat conçu pour être utilisé à haute température n'est pas capable de refroidir efficacement un substrat pour le maintenir à des températures inférieures à 80°C .

D'autre part le substrat est maintenu sur le porte-substrat grâce à un système électrostatique qui ne nécessite pas d'alimentation externe pendant le traitement. Ce système est constitué d'électrodes en métal disposées dans une couche fonctionnelle en un matériau contenant des ions mobiles (verre borosilicate) ou ayant une constante diélectrique élevée (titanate de baryum ou de strontium). Pour fixer le substrat, une tension électrique est appliquée aux bornes des deux électrodes. Sous l'effet du champ électrique appliqué, les ions mobiles se déplacent et créent des dipôles électriques élémentaires. La somme des champs électriques élémentaires générés par les dipôles crée un champ élevé qui subsiste après que la tension électrique ait été coupée. C'est ce champ électrique rémanent qui va maintenir le substrat sur le porte-substrat pendant le traitement.
Cette solution n'est pas utilisable dans le cas présent d'une opération de gravure sèche dans un milieu plasma sous vide avec une polarisation alternative du substrat à des fréquences comprises entre 30Khz et 13,56Mhz. En effet sous l'effet de cette tension alternative, les dipôles électriques se retournent, annulant le champ électrique de fixation du substrat qui n'est plus maintenu sur le porte-substrat.

Par ailleurs on connaît du document US-6,268,994 un mandrin, destiné à supporter un échantillon, muni d'un dispositif de refroidissement et composé de deux parties, une base conductrice et un cadre, solidarisées par des boulons passant dans des orifices ménagés dans la base conductrice. Ces deux parties sont reliées électriquement et thermiquement. La jonction entre la base conductrice et le cadre peut se faire au moyen d'un adhésif de type époxy, d'une brasure métallique ou de graisse thermiquement conductrice. L'échantillon est fixé électrostatiquement sur la base composée d'une pièce conductrice recouverte successivement d'une première couche isolante, d'une couche conductrice et d'une seconde couche isolante. Ce mandrin ne résout pas le problème de la manipulation d'échantillons minces ou fragilisés.

La présente invention propose un dispositif destiné à supporter une tranche amincie de substrat semi-conducteur en vue de son traitement dans un milieu plasma sous vide qui ne présente pas les inconvénients des dispositifs connus de l'art antérieur. En particulier le dispositif selon l'invention procure au substrat un support rigide solidaire du substrat et amovible pour permettre sa manipulation aisée. En outre le dispositif selon l'invention est apte à maintenir la température du substrat à une valeur inférieure à 80°C pendant toute la durée d'un traitement. Enfin le dispositif selon l'invention doit permettre après traitement la libération aisée et totale du substrat, éventuellement découpé pour former des circuits.

L'objet de la présente invention est un dispositif destiné à supporter un substrat semi-conducteur, comprenant un porte-échantillon solidaire de la chambre de procédé comportant un système de refroidissement et des moyens de liaison électrique. Ce dispositif comprend en outre un élément intermédiaire fixé par voie électrostatique ou au moyen de mors sur ledit porte-échantillon et relié électriquement et thermiquement audit porte-échantillon, ledit élément comportant
- une base constituée d'un premier matériau ayant une conductivité thermique supérieure à celle dudit substrat,
- une première couche recouvrant ladite base constituée d'un deuxième matériau ayant une rigidité diélectrique élevée,
- une première et une deuxième électrodes disposées sur ladite première couche,
- une deuxième couche recouvrant ladite première couche et lesdites électrode, constituée d'un troisième matériau ayant une rigidité diélectrique élevée.

L'élément intermédiaire est amovible et présente une rigidité suffisante pour permettre la manipulation du substrat aminci qu'il supporte.

Avantageusement le dispositif selon l'invention permet des fréquences de fixation / détachement du porte-échantillon de l'ensemble élément intermédiaire-substrat aminci qui sont du même ordre que pour un substrat seul. L'invention autorise l'utilisation des équipements classiques sans leur apporter de modifications (bras de robot, portes de chambres, porte-substrats, cassettes de transport...) et permet de refroidir l'élément intermédiaire par le système de refroidissement classique consistant en l'injection d'une fuite raisonnable d'hélium sous l'élément intermédiaire.
L'ensemble élément intermédiaire-substrat ainsi obtenu possède des dimensions du même ordre de grandeur que le substrat seul avant amincissement, c'est à dire un diamètre de 150mm ou 200mm, une épaisseur du même ordre que celle du substrat avant amincissement et un poids inférieur à 500g. L'ensemble élément intermédiaire-substrat est léger et aisément transportable sans risque de dégradation du substrat aminci.

Le matériau constituant la base de l'élément intermédiaire doit posséder une conductivité thermique bien supérieure à celle du substrat, et de préférence la plus élevée possible, de manière à faciliter l'évacuation des calories générées par le traitement par plasma du substrat vers le porte-échantillon refroidi. Selon une première forme d'exécution de l'invention, le premier matériau est un métal. Celui-ci est de préférence choisi parmi le cuivre et l'aluminium.
Une première couche d'un matériau diélectrique isole les électrodes de la base. Ce matériau doit être capable de résister sans claquer à des tensions de quelques kilovolts. Le matériau constitutif de la première couche doit en outre posséder une conductivité thermique la plus élevée possible pour ne pas créer une barrière thermique entre le substrat et la base de l'élément intermédiaire. Bien entendu, on s'efforcera si possible d'optimiser simultanément ces deux critères Selon une deuxième forme d'exécution, ledit deuxième matériau est un oxyde d'aluminium Al₂O₃, comme par exemple une couche d'aluminium anodisé formée sur la surface de la base ou des électrodes selon que l'une ou les autres sont en aluminium.
Cette première couche isolante est en contact avec des électrodes. Ces électrodes peuvent par exemple être sous forme d'une fine couche d'un matériau électriquement conducteur, notamment obtenue par dépôt de matériau conducteur sur la première couche isolante. Selon une troisième forme d'exécution, les électrodes sont en un métal. Celui-ci est de préférence choisi parmi le cuivre et l'aluminium.
Les électrodes sont recouvertes d'une deuxième couche isolante capable de résister sans claquer à des tensions de quelques kilovolts et très bon conducteur thermique afin de contribuer au refroidissement du substrat. Le choix du matériau de cette deuxième couche isolante répond à des critères électriques et thermiques analogues à ceux du matériau de la première couche isolante. Toutefois, comme ce matériau est soumis localement à l'action dégradante du plasma, il est avantageux d'utiliser un matériau qui puisse être enlevé et remplacé facilement. Selon une quatrième forme d'exécution, le troisième matériau est un polymère souple. Selon une variante ce polymère est un polymère adhésif. Selon une autre variante ce polymère flexible est choisi parmi le polytétrafluoréthylène (PTFE), un polychlorure de vinyle (PVC), un polyéthylène (PE) et un polyamide (PA).

La deuxième couche isolante peut être constituée par exemple d'un film de polymère, de préférence adhésif sur sa face en contact, avec les électrodes ou encore un matériau que l'on peut déposer à la tournette et enlever chimiquement à l'aide de solvants appropriés comme par exemple un polyimide. Par ailleurs il est important que la surface de la face supérieure de cette couche isolante soit parfaitement plane pour ne pas générer des contraintes dans le substrat aminci à maintenir.

Le dispositif selon la présente invention présente de nombreux avantages. D'abord l'élément intermédiaire peut être réalisé à partir d'un matériau bon marché par rapport au quartz, comme un disque d'aluminium. Puis il n'est pas sensible aux défauts, tels que les rayures, qui endommagent le quartz et lui font perdre en partie ses qualités de transparence. Ensuite il ne nécessite pas d'environnement particulier, comme la lumière inactinique dans le cas du quartz et des films sensibles aux rayonnements ultraviolets. Enfin, en cas d'usure, il est très facile de remplacer le diélectrique supérieur, notamment si celui-ci est un film de polymère ou s'il est déposé à la tournette.

Selon un mode de réalisation de l'invention, le substrat est fixé sur l'élément intermédiaire par voie électrostatique et l'élément intermédiaire est fixé sur le porte échantillon par voie électrostatique. Le porte-échantillon comprend des électrodes entre lesquelles une tension électrique de quelques kilovolts est appliquée de telle sorte que l'élément intermédiaire se trouve maintenu contre le porte-échantillon par la pression électrostatique résultant de l'application de la tension électrique. La fixation par voie électrostatique de l'élément intermédiaire sur le porte-échantillon s'effectue de manière analogue à la fixation du substrat sur l'élément intermédiaire décrite précédemment. Une tension électrique de quelques kilovolts est appliquée entre les électrodes de telle sorte que l'élément intermédiaire se trouve maintenu contre le porte-échantillon.
Dans ce cas, l'élément intermédiaire est de préférence un disque de diamètre du même ordre de grandeur que la dimension du substrat.

Selon un autre mode de réalisation, le substrat est fixé sur l'élément intermédiaire par voie électrostatique et l'élément intermédiaire est fixé sur le porte échantillon au moyen de mors. On entend par « mors » tout moyen de fixation par une force exercée sur l'élément intermédiaire, et ayant pour effet de plaquer l'élément intermédiaire sur le porte-échantillon, l'élément intermédiaire pouvant être désolidarisé du porte-échantillon par simple neutralisation de cette force. Un tel mode de fixation est notamment décrit dans le document EP-1 263 025.
Dans ce mode de réalisation, l'élément intermédiaire est un disque de diamètre légèrement supérieur à la dimension du substrat pour ménager une zone d'appui pour les mors.
Dans ce cas, ladite base a de préférence une épaisseur au moins égale à 1 mm, et de préférence comprise entre 1mm et 2mm, pour permettre la prise entre les mâchoires des mors.

Selon un premier aspect de l'invention, un film d'hélium sous pression est ménagé entre l'élément intermédiaire et le porte-échantillon. Un flux d'hélium, utilisé comme gaz inerte permettant l'échange thermique, est envoyé entre la face supérieure du porte-échantillon et la face inférieure de l'élément intermédiaire, afin de créer un balayage gazeux et de former un film permanent de gaz.
Selon un deuxième aspect, un film d'hélium sous pression est ménagé entre l'élément intermédiaire et le substrat. De l'hélium est également introduit entre la face supérieure de l'élément intermédiaire et la face inférieure du substrat.
La pression d'hélium doit être d'au moins 10 mbars afin d'assurer un transport thermique efficace.
La pression électrostatique se rétablit dès l'admission des gaz de traitement sous l'action du plasma qui est un milieu gazeux et conducteur de l'électricité. Sous l'effet de la pression électrostatique, le substrat de silicium est plaqué contre l'élément intermédiaire et la chaleur générée à sa surface est évacuée dans les meilleures conditions. A la fin du traitement, l'admission des gaz et le plasma sont arrêtés, de même que la tension électrique alimentant les contacts de l'élément intermédiaire. L'élément intermédiaire portant le substrat aminci est alors retiré de la machine.
Si nécessaire, l'ensemble élément intermédiaire-substrat peut être placé hors de la machine sur une pièce munie, comme le porte-échantillon, de deux contacts électriques entre lesquels on applique une tension de signe opposé à celle utilisée pour le maintien du substrat. Le substrat est maintenant complètement libéré et prêt pour l'étape suivante.

Selon un mode de réalisation particulier de l'invention, la première électrode a sensiblement la forme d'un disque et la deuxième électrode a sensiblement la forme d'un anneau entourant la première électrode. Afin d'établir la continuité électrique avec le porte-échantillon, chacune des électrodes comporte respectivement un prolongement, recouvert de la première couche pour l'isoler de la base de l'élément intermédiaire qu'il traverse jusqu'à sa face arrière pour définir deux points de contact électriques. A l'extérieur de la machine de traitement par plasma, le substrat est déposé sur un élément intermédiaire muni de deux contacts électriques en regard des contacts du porte-échantillon. Une tension électrique de quelques kilovolts est appliquée entre les deux électrodes pendant quelques minutes. Le substrat se trouve alors maintenu contre l'élément intermédiaire par la pression électrostatique résultant de l'application de la tension électrique. L'ensemble élément intermédiaire-substrat est alors introduit dans la machine et fixé sur le porte-échantillon par un moyen électrostatique ou au moyen de mors à ouverture facile. Au moment de sa mise en place sur le porte-échantillon, la continuité électrique s'établit entre les contacts de l'élément intermédiaire et ceux du porte-échantillon, et une tension de quelques kilovolts entre les électrodes est rétablie.

Selon une autre forme d'exécution de l'invention, l'élément intermédiaire comporte en outre
- une troisième couche recouvrant la base du côté opposé à la première couche, constituée d'un quatrième matériau ayant une rigidité diélectrique élevée,
- une troisième et une quatrième électrodes disposées sur la troisième couche,
- une quatrième couche recouvrant la troisième couche et les troisième et quatrième électrodes, constituée d'un cinquième matériau ayant une rigidité diélectrique élevée.

La troisième couche isolante assure la même fonction que la première couche isolante du côté opposé de la base, c'est à dire isoler électriquement les électrodes de la base. Le quatrième matériau doit donc présenter des caractéristiques similaires à celle du deuxième matériau constituant la première couche isolante. De préférence le quatrième matériau est un oxyde d'aluminium Al₂O₃, comme par exemple une couche d'aluminium anodisé formée sur la surface de la base ou des électrodes selon que l'une ou les autres sont en aluminium.
Les troisième et quatrième électrodes peuvent par exemple être sous forme d'une fine couche d'un matériau électriquement conducteur notamment obtenue par dépôt de matériau conducteur sur la troisième couche isolante. Avantageusement les électrodes sont en un métal. Celui-ci est de préférence choisi parmi le cuivre et l'aluminium.
La quatrième couche isolante assure la même fonction que la deuxième couche isolante du côté opposé de la base. Le cinquième matériau doit donc présenter des caractéristiques similaires à celle du troisième matériau constituant la deuxième couche isolante. De préférence le deuxième matériau est un polymère souple. Selon une variante ce polymère est un polymère adhésif. Selon une autre variante ce polymère flexible est choisi parmi le polytétrafluoréthylène (PTFE), un polychlorure de vinyle (PVC), un polyéthylène (PE) et un polyamide (PA).
Selon un mode de réalisation particulier de l'invention, la troisième électrode a sensiblement la forme d'un disque et la quatrième électrode a sensiblement la forme d'un anneau entourant la troisième électrode. Afin d'établir la continuité électrique avec le porte-échantillon, chaque électrode comporte un prolongement recouvert de la troisième couche qui l'isole de la base de l'élément intermédiaire qu'il traverse jusqu'à sa face arrière, pour définir deux points de contact électriques. Avantageusement le prolongement de la troisième électrode est commun avec celui de la première électrode et le prolongement de la quatrième électrode est commun avec celui de la deuxième électrode. L'élément intermédiaire présente ainsi seulement deux points de contact électrique avec le porte-échantillon.

La présente invention a encore pour objet un procédé de manipulation d'un substrat semi-conducteur au moyen d'un dispositif tel que décrit précédemment. Le procédé comprend les étapes suivantes:
- on fixe par voie électrostatique le substrat sur un élément intermédiaire,
- on introduit l'élément intermédiaire portant le substrat dans une chambre de procédé,
- on fixe l'élément intermédiaire sur un porte-échantillon, solidaire de la chambre, comportant un système de refroidissement et des moyens de liaison électrique avec l'élément intermédiaire,
- on soumet le substrat à un traitement dans un milieu plasma sous vide,
- on détache du porte-échantillon l'élément intermédiaire portant le substrat traité,
- on enlève le substrat de l'élément intermédiaire.

De préférence l'élément intermédiaire est fixé sur le porte-échantillon par voie électrostatique. Une tension électrique de quelques kilovolts est appliquée entre les électrodes de telle sorte que l'élément intermédiaire se trouve maintenu contre le porte-échantillon. L'élément intermédiaire peut aussi être fixé sur le porte-échantillon au moyens de mors.

La présente invention a comme avantage de permettre de traiter dans les meilleures conditions possibles de vitesse de traitement par plasma des substrats amincis sans les endommager. D'abord la température des substrats peut être maintenue à une valeur inférieure à environ 80°C tout en permettant des vitesses de traitement élevées. Ensuite elle permet de prendre les circuits individualisés sans effort, donc sans dommage, après leur séparation. Enfin le substrat ne subit aucune manipulation périlleuse avant ou après le traitement par plasma, contrairement aux méthodes de fixation de substrats amincis sur un support de quartz avec des films sensibles soit à la température soit aux rayonnements ultraviolets.

D'autres caractéristiques et avantages de la présente invention apparaîtront au cours de la description suivante de modes de réalisation donnés à titre illustratif, mais nullement limitatif, et dans le dessin annexé sur lequel
- la figure 1 représente le dispositif selon la présente invention comprenant un élément intermédiaire selon un mode de réalisation de l'invention,
- la figure 2 montre une variante du mode de réalisation de la figure 1,
- la figure 3 montre un élément intermédiaire selon un autre mode de réalisation de l'invention.

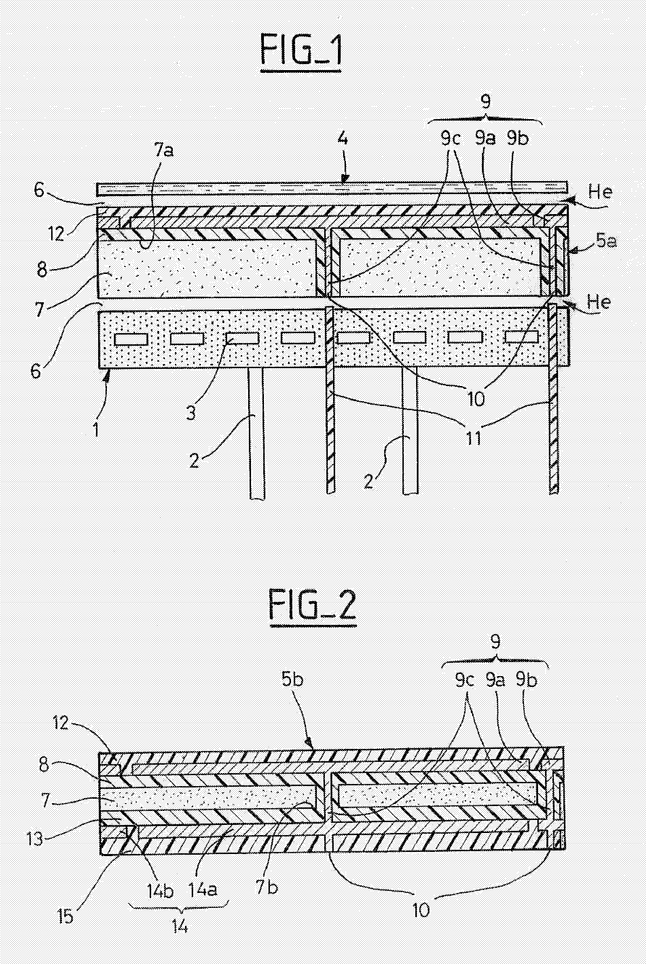

Comme le montre la figure 1, le dispositif selon l'invention comporte un porte-échantillon 1, solidaire de la chambre de procédé, muni d'un système de refroidissement comprenant des tubulures 2 pour l'alimentation en fluide caloporteur et son évacuation vers un dispositif échangeur de chaleur par exemple, et des passages 3 pour la circulation de ce fluide. Un substrat 4, fixé sur un élément intermédiaire 5a, est disposé sur ce porte-échantillon 1. Un gaz inerte caloporteur tel que l'hélium est injecté entre la face supérieure du porte-échantillon 1 et la face inférieure de l'élément intermédiaire 5a, et aussi entre la face inférieure du substrat 4 et la face supérieure de l'élément intermédiaire 5a de manière à former une couche mince 6.
L'élément intermédiaire 5a, ayant ici la forme d'un disque, est composé d'une base 7 constituée d'un matériau très bon conducteur de la chaleur comme un métal, tel que du cuivre (Cₜₕ=401W/m.K) ou de l'aluminium (Cₜₕ = 237 W/m.K). La conductivité thermique du matériau constitutif de la base **7** doit être élevée, et bien supérieure à celle du substrat **4,** de manière à drainer vers la couche d'hélium **6** les calories générées au niveau du substrat **4** par le traitement par plasma.
La base 7 est de préférence en aluminium. La face **7a** de la base **7** du côté destiné à recevoir le substrat, est recouverte d'une couche **8** d'un matériau isolant ayant une rigidité diélectrique élevée, ici par exemple de l'alumine Al₂O₃. Cette couche isolante peut être notamment obtenue par anodisation de l'aluminium de la surface supérieure de la base **7.** La couche **8** est revêtue d'une couche conductrice 9 constituant des électrodes. La couche **8** a pour rôle d'isoler électriquement le matériau de la base **7** de la couche conductrice **9.** De préférence la couche conductrice **9** discontinue, de quelques microns d'épaisseur, est de préférence en cuivre. La couche conductrice **9** comprend deux électrodes concentriques, l'une ayant le forme d'un disque central **9a** entouré de la seconde formant un anneau 9b. Cette couche conductrice **9** comporte deux prolongements **9c** isolés électriquement de la base **7** par la couche **8 ;** l'un est dans le prolongement du disque central 9a et l'autre en périphérie prolonge l'anneau **9b.** Ces prolongements 9c émergent à la face arrière de l'élément intermédiaire **5a** pour définir deux zones de contact électrique **10.** Une fois l'élément intermédiaire **5a** placé sur le porte-échantillon **1,** ces zones **10** se trouvent en contact avec l'extrémité de deux liaisons électriques **11** leur correspondant qui émergent du porte-échantillon **1,** ce qui permet d'imposer une tension électrique entre les électrodes **9a** et **9b.**
La couche conductrice **9** est protégée par une deuxième couche isolante 12 d'un matériau ayant une rigidité diélectrique élevée. Dans le cas présent on utilise un film en polytéréphtalate d'éthylène (PET) de 70µm à 170µm d'épaisseur, adhésif sur sa face inférieure en contact avec la face supérieure de la couche conductrice 9.
Dans ce mode de réalisation, l'élément intermédiaire 5a a le même diamètre D que le substrat **4.** La base **7** et chacune des couches **8, 9, 12** qui la recouvre ont également ce diamètre D. L'élément intermédiaire **5a** peut être fixé sur le porte-échantillon **1** par voie électrostatique grâce à des électrodes (non représentées) comprises dans le porte-échantillon **1,** de la même manière que le substrat **4** sur l'élément intermédiaire **5a.**

La figure 2 représente un élément intermédiaire **5b** selon une variante du mode de réalisation précédent. Une troisième couche isolante **13** est déposée sur la face **7b** de la base 7 située du côté opposé au substrat et qui n'est pas recouverte de la première couche isolante **8.** La couche isolante **13** présente des caractéristiques similaires à celles de la couche **8.** Elle est constituée d'un matériau isolant ayant une rigidité diélectrique élevée, ici par exemple de l'alumine Al₂O₃.
Sur la couche isolante **13** est déposée une couche conductrice **14** discontinue, de quelques microns d'épaisseur, de préférence en cuivre. La couche conductrice **14** comprend deux électrodes concentriques, l'une ayant le forme d'un disque central **14a** entouré de la seconde formant un anneau **14b.** Les électrodes **14a** et **14b** sont reliées électriquement aux prolongements des électrodes **9a** et **9b** respectivement, et émergent de l'élément intermédiaire par les zones de contact **10.**
La couche conductrice **14** est protégée par une quatrième couche isolante **15** d'un matériau ayant une rigidité diélectrique élevée. Comme la deuxième couche **12,** la couche isolante **15** peut être constituée d'un film en polytéréphtalate d'éthylène (PET) de 70µm à 170µm d'épaisseur, adhésif sur sa face inférieure en contact avec la face supérieure de la couche conductrice **14.**
Dans ce mode de réalisation, l'élément intermédiaire **5b** a le même diamètre D que le substrat **4.** La base **7** et chacune des couches **13, 14, 15** qui la recouvre ont également ce diamètre D. L'élément intermédiaire **5b** peut être fixé sur le porte-échantillon **1** par voie électrostatique grâce à aux électrodes **14a** et **14b** comprises dans l'élément intermédiaire **5b,** de la même manière que le substrat 4 peut être fixé sur l'élément intermédiaire **5b** par voie électrostatique grâce à aux électrodes **9a** et **9b** également comprises dans l'élément intermédiaire **5b.**

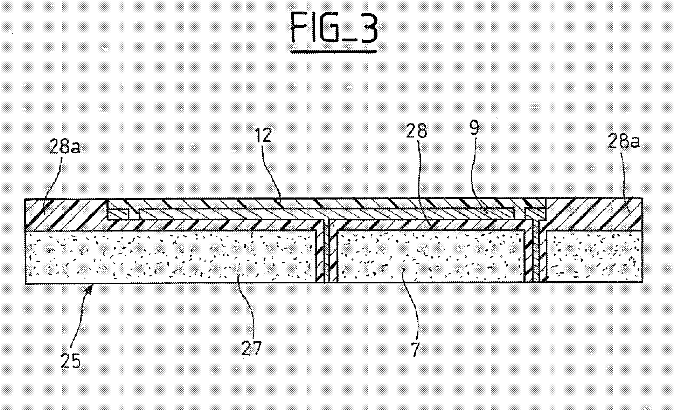

Dans le mode de réalisation de l'invention illustré sur la figure 3, les objets similaire à ceux de la figure 1 sont désignés par la même référence. Ce mode de réalisation diffère de celui de la figure 1 en ce que l'élément intermédiaire **25** a un diamètre D' supérieur à celui du substrat **4** afin de permettre sa fixation par des mors sur le porte-échantillon **1.** Un tel mode de fixation est notamment décrit dans le document EP-1 263 025. La base **27** et la première couche isolante **28** ont un diamètre D' identique à celui de l'élément **25.** La couche conductrice **9** et la deuxième couche isolante **12** ont un diamètre D identique à celui du substrat **4.** La première couche isolante **28** présente donc une surépaisseur **28a** à sa périphérie égale à la somme des épaisseurs des couches **9** et **12** afin de combler la différence de diamètre. Le moyen de fixation de l'élément **25** sur la porte-échantillon **1** vient prendre appuie sur cette surépaisseur **28a.**

## Revendications

1. Dispositif destiné à supporter un substrat (4) semi-conducteur, comprenant un porte-échantillon (1) solidaire de la chambre de procédé comportant un système de refroidissement (2, 3) et des moyens de liaison électrique, **caractérisé en ce que** ledit dispositif comprend en outre un élément (5a, 5b, 25) intermédiaire fixé par voie électrostatique ou au moyen de mors sur ledit porte-échantillon (1) et relié électriquement et thermiquement audit porte-échantillon (1), ledit élément comportant
- une base (7) constituée d'un premier matériau ayant une conductivité thermique supérieure à celle dudit substrat (4),
- une première couche (8) recouvrant ladite base (7) constituée d'un deuxième matériau ayant une rigidité diélectrique élevée,
- une première et une deuxième électrodes (9a, 9b) disposées sur ladite première couche (8),
- une deuxième couche (12) recouvrant ladite première couche (8) et lesdites électrodes (9a, 9b), constituée d'un troisième matériau ayant une rigidité diélectrique élevée,
ledit élément (5a, 5b, 25) intermédiaire étant amovible et présentant une rigidité suffisante pour permettre la manipulation du substrat (4) aminci qu'il supporte.

2. Dispositif selon la revendication 1, dans lequel ledit premier matériau est un métal.

3. Dispositif selon l'une des revendications 1 et 2, dans lequel lesdites électrodes (9a, 9b) sont en métal.

4. Dispositif selon l'une des revendications 2 et 3, dans lequel ledit métal est choisi parmi le cuivre et l'aluminium.

5. Dispositif selon l'une des revendications précédentes, dans lequel chacune desdites première et deuxième électrodes (9a, 9b) comporte respectivement un prolongement (9c), recouvert de ladite première couche (8) pour l'isoler de ladite base (7), qui traverse ladite base (7) jusqu'à sa face arrière pour définir deux points de contact (10) électriques.

6. Dispositif selon l'une des revendications précédentes, dans lequel ledit deuxième matériau est un oxyde d'aluminium.

7. Dispositif selon l'une des revendications précédentes, dans lequel ledit troisième matériau est un polymère souple.

8. Dispositif selon l'une des revendications précédentes, dans lequel ladite première électrode (9a) a sensiblement la forme d'un disque et ladite deuxième électrode (9b) a sensiblement la forme d'un anneau entourant ladite première électrode (9a).

9. Dispositif selon l'une des revendications précédente, dans lequel un film (6) d'hélium sous pression est ménagé entre ledit élément (5a, 5b, 25) intermédiaire et ledit porte-échantillon (1).

10. Dispositif selon l'une des revendications précédente, dans lequel un film (6) d'hélium sous pression est ménagé entre ledit élément (5a, 5b, 25) intermédiaire et ledit substrat (4).

11. Dispositif selon l'une des revendications 1 à 10, dans lequel ledit élément (25) intermédiaire est fixé sur le porte échantillon (1) au moyen de mors.

12. Dispositif selon la revendication 11, dans lequel ledit élément (25) intermédiaire est un disque de diamètre supérieur à la dimension dudit substrat.

13. Dispositif selon l'une des revendications 11 et 12, dans lequel ladite base (7) a une épaisseur au moins égale à 1 mm.

14. Dispositif selon l'une des revendications 1 à 10, dans lequel ledit élément (5a, 5b) intermédiaire est fixé sur le porte-échantillon (1) par voie électrostatique.

15. Dispositif selon la revendication 14, dans lequel ledit porte-échantillon (1) comprend des électrodes entre lesquelles une tension électrique est appliquée

16. Dispositif selon la revendication 14, dans lequel ledit élément (5b) intermédiaire comporte en outre
- une troisième couche (13) recouvrant ladite base (7) du côté opposé à ladite première couche (8), constituée d'un quatrième matériau ayant une rigidité diélectrique élevée,
- une troisième et une quatrième électrodes (14a, 14b) disposées sur ladite troisième couche (13),
- une quatrième couche (15) recouvrant ladite troisième couche (13) et lesdites troisième et quatrième électrodes (14a, 14b), constituée d'un cinquième matériau ayant une rigidité diélectrique élevée.

17. Dispositif selon la revendication 16, dans lequel ledit quatrième matériau est un oxyde d'aluminium Al₂O₃

18. Dispositif selon l'une des revendications 16 et 17, dans lequel lesdites électrodes (14a, 14b) sont en métal.

19. Dispositif selon la revendications 18, dans lequel ledit métal est choisi parmi le cuivre et l'aluminium.

20. Dispositif selon l'une des revendications 16 à 19, dans lequel ladite troisième électrode (14a) a sensiblement la forme d'un disque et ladite quatrième électrode (14b) a sensiblement la forme d'un anneau entourant ladite troisième électrode (14a).

21. Dispositif selon l'une des revendications 16 à 20, dans lequel chacune desdites troisième et quatrième électrodes (14a, 14b) comporte respectivement un prolongement (14c), recouvert de ladite troisième couche (13) pour l'isoler de ladite base, qui traverse ladite base (7) jusqu'à sa face arrière pour définir deux points de contact (10) électriques.

22. Dispositif selon la revendications 18, dans lequel lesdits prolongements (14c) desdites troisième et quatrième électrodes (14a, 14b) sont communs respectivement avec les prolongement (9c) desdites première et deuxième électrodes (9a, 9b).

23. Dispositif selon l'une des revendications 16 à 22, dans lequel ledit cinquième matériau est un polymère souple.

24. Procédé de manipulation d'un substrat (4) semi-conducteur au moyen d'un dispositif selon l'une des revendications précédentes, comprenant les étapes suivantes:
- on fixe par voie électrostatique ledit substrat (4) sur un élément (5a, 5b, 25) intermédiaire,
- on introduit ledit élément (5a, 5b, 25) intermédiaire portant ledit substrat (4) dans une chambre de procédé,
- on fixe ledit élément (5a, 5b, 25) intermédiaire sur un porte-échantillon (1), solidaire de ladite chambre, comportant un système de refroidissement (2, 3) et des moyens de liaison électrique (11) avec ledit élément (5a, 5b, 25) intermédiaire,
- on soumet ledit substrat (4) à un traitement dans un milieu plasma sous vide,
- on détache dudit porte-échantillon (1) ledit élément (5a, 5b, 25) intermédiaire portant ledit substrat (4) traité,
- on enlève ledit substrat (4) dudit élément (5a, 5b, 25) intermédiaire.

25. Procédé selon la revendication 24, dans lequel ledit élément (5a, 5b) intermédiaire est fixé sur ledit porte-échantillon (1) par voie électrostatique.

26. Procédé selon la revendication 24, dans lequel ledit élément (25) intermédiaire est fixé sur ledit porte-échantillon (1) au moyens de mors.
